# EUROPEAN PATENT SPECIFICATION

(11) **EP 0 738 920 B1**
(45) Date of publication and mention of the grant of the patent: **10.03.1999**
(21) Application number: 96200891.8
(22) Date of filing: 02.04.1996
(51) Int. Cl.: G03C 8/06, G03F 7/07

(54) **Imaging element for making an improved printing plate according to the silver salt diffusion transfer process**
Bildelement zur Herstellung einer verbesserten Druckplatte nach dem Silbersalz-Diffusionsübertragungsverfahren
Elément formateur d'images pour la préparation d'une plaque d'impression améliorée obtenue suivant le procédé de diffusion-transfert de sel d'argent

(30) Priority: 21.04.1995 EP 95201016
(43) Date of publication of application: 23.10.1996
(73) Proprietor: AGFA-GEVAERT N.V., 2640 Mortsel (BE)
(72) Inventor: Coppens, Paul, Agfa-Gevaert N.V., 2640 Mortsel (BE); Hoes, Eric, Agfa-Gevaert N.V., 2640 Mortsel (BE); De Keyzer, René, Agfa-Gevaert N.V., 2640 Mortsel (BE); Van der Linden, Bart, Agfa-Gevaert N.V., 2640 Mortsel (BE)

(56) References cited:
- EP-A- 0 637 777
- DE-A- 1 447 900
- US-A- 4 510 228

## Description

### 1. Field of the invention.

The present invention relates to an imaging element, for making improved lithographic printing plates according to the silver salt diffusion transfer process.

The present invention further relates to a method for making improved lithographic printing plates according to the silver salt diffusion transfer process.

### 2. Background of the invention.

The principles of the silver complex diffusion transfer reversal process, hereinafter called DTR-process, have been described e.g. in US-P-2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellent ink-receptive areas on a water-receptive ink-repellent background.

The DTR-image can be formed in the image receiving layer of a sheet or web material which is a separate element with respect to the photographic silver halide emulsion material (a so-called two-sheet DTR element) or in the image receiving layer of a so-called single-support-element, also called mono-sheet element, which contains at least one photographic silver halide emulsion layer integral with an image receiving layer in waterpermeable relationship therewith. It is the latter mono-sheet version which is preferred for the preparation of offset printing plates by the DTR method.

Two types of the mono-sheet DTR offset printing plate exist. According to a first type disclosed in e.g. US-P-4,722,535 and GB-1,241,661 a support is provided in the order given with a silver halide emulsion layer and a layer containing physical development nuclei serving as the image-receiving layer. After information-wise exposure and development the imaged element is used as a printing plate without the removal of the emulsion layer.

According to a second type of mono-sheet DTR offset printing plate a hydrophilic support, mostly anodized aluminum, is provided in the order given with a layer of physical development nuclei and a silver halide emulsion layer. After information-wise exposure and development the imaged element is treated to remove the emulsion layer so that a support carrying a silver image is left wich is used as a printing plate. Such type of lithographic printing plate is disclosed e.g. in US-P-3,511,656.

As for other printing plates it is required that the offset printing plates belonging to the second type of mono-sheet DTR offset printing plates have good printing properties e.g. a high printing endurance, good ink acceptance in the printing areas and no ink acceptance in the non-printing areas (no staining). It is furthermore desirable that the printing plate exhibits a high resolving power.

Offset printing plates belonging to the second type of mono-sheet DTR offset printing plates have in most respects good printing properties. However, these printing plates exhibit a reduced printing screen range, due to a bad match between the smallest point visible on the printing plate at a given exposure and the smallest point on a print from said printing plate causing an undesirable decrease of the grey values that can be reproduced which is a serious drawback. So, there is still room for improvement of this type of printing plates.

### 3. Summary of the invention.

It is an object of the present invention to provide an imaging element for making offset printing plates according to the silver salt diffusion transfer process with a good match between the printing plate and the print thereof.

It is another object of the present invention to provide a method for making offset printing plates with said imaging element having a good match between the printing plate and the print thereof.

Further objects of the present invention will become clear from the description hereinafter.

According to the present invention there is provided an imaging element comprising in the order given on a hydrophilic surface of a support (i) an image receiving layer containing physical development nuclei, (ii) a photosensitive layer containing a silver halide emulsion being in water permeable relationship with said image receiving layer and (iii) an antistress composition in water permeable relationship with said image receiving layer, said antistress composition comprising unhardened gelatin in an amount ranging from 0.60 to 1.75 g/m² , characterized in that at least 50% by weight of said gelatin belongs to one or more gelatin species whereof a 10% by weight aqueous solution at 36°C and pH 6 has a viscosity lower than 35 mPa.s at a shearing rate of 1000 s⁻¹.

According to the present invention there is also provided a method for making an offset printing plate according to the silver salt diffusion transfer process comprising the steps of:
(a) image-wise exposing an imaging element according to the present invention,
(b) applying an aqueous alkaline solution to the imaging element in the presence of (a) developing agent(s) and (a) silver halide solvent(s) ,
(c) treating the imaging element to remove the layer(s) on top of said image receiving layer, thereby uncovering said silver image formed in said image receiving layer.

### 4. Detailed description of the invention.

Lithographic printing plates are obtained according to the DTR-process having good printing properties and a low dot gain by using an imaging element comprising an upper composition (antistress composition) comprising unhardened gelatin in an amount ranging from 0.60 to 1.75 g/m² and whereof at least 50% by weight of said gelatin belongs to one or more gelatin species whereof a 10% by weight aqueous solution at 36°C and pH 6 has a viscosity lower than 35 mPa.s at a shearing rate of 1000 s⁻¹.

The antistress composition according to the invention comprises unhardened gelatin in an amount ranging from 0.60 to 1.75 g/m², more preferably in an amount ranging from 0.80 to 1.25 g/m².

At least 50%, more preferably at least 75%, most preferably at least 90% by weight of said unhardened gelatin belongs to one or more gelatin species whereof a 10% by weight aqueous solution at 36°C and pH 6 has a viscosity lower than 35 mPa.s, more preferably lower than 30 mPa.s at a shearing rate of 1000 s⁻¹.

The antistress composition can comprises more than one species of unhardened gelatin whereof a 10% by weight aqueous solution at 36°C and pH 6 has a viscosity lower than 35 mPa.s at a shearing rate of 1000 s⁻¹, but it is preferred for practical reasons that said composition comprises only one such gelatin.

The antistress composition may contain small particles e.g. matting agents with a mean diameter between 0.2 and 10 µm in order to improve the diffusion of processing solutions through said antistress composition.

The antistress composition can comprise more than one layer, but for practical reasons it is preferred that said composition consist of one layer.

The antistress layer according to the invention has to be in water permeable relationship with said image receiving layer in the imaging element. Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or the complexed silver.

The imaging element is preferably prepared by coating the different layers on a hydrophilic surface of a support. Alternatively the different layers may be laminated to said image receiving layer from a temporary base holding the layers in reverse order as disclosed in US-P 5,068,165.

Said hydrophilic surface of a support can be a hardened hydrophilic layer, containing a hydrophilic binder and a hardening agent coated on a flexible support.

Such hydrophilic binders are disclosed in e.g. EP-A 450,199, which therefor is incorporated herein by reference. Preferred hardened hydrophilic layers comprise partially modified dextrans or pullulan hardened with an aldehyde as disclosed in e.g. EP-A 514,990 which therefor is incorporated herein by reference. More preferred hydrophilic layers are layers of polyvinyl alcohol hardened with a tetraalkyl orthosilicate and preferably containing SiO₂ and/or TiO₂ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199 which therefor are incorporated herein by reference.

Flexible supports may be opaque or transparent, e.g. a paper support or resin support. When a paper support is used preference is given to one coated at one or both sides with an Alpha-olefin polymer. It is also possible to use an organic resin support e.g. poly(ethylene terephthalate) film or poly-Alpha-olefin films. The thickness of such organic resin film is preferably comprised between 0.07 and 0.35 mm. These organic resin supports are preferably coated with a hydrophilic adhesion layer which can contain water insoluble particles such as silica or titanium dioxide.

Said hydrophilic surface of a support is preferably a hydrophilic metallic support e.g. an aluminium foil.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results. Preferably the aluminum foil has a roughness with a CLA value between 0.2 and 1.5 µm, an anodization layer with a thickness between 0.4 and 2.0 µm and is posttreated with an aqueous bicarbonate solution.

According to the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

The roughening is preferably preceded by a degreasing treatment mainly for removing greasy substances from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

After roughening and optional chemical etching the aluminum foil is anodized which may be carried out as follows.

An electric current is passed through the grained aluminum foil immersed as an anode in a solution containing an acid. An electrolyte concentration from 1 to 70 % by weight can be used within a temperature range from 0-70°C. The anodic current density may vary from 1-50 A/dm² and a voltage within the range 1-100 V to obtain an anodized film weight of 1-8 g/m² Al₂O₃.H₂O. The anodized aluminum foil may subsequently be rinsed with demineralised water within a temperature range of 10-80°C.

After the anodizing step sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminium". Different types of sealing of the porous anodized aluminum surface exist.

Preferably, said sealing is performed by treating a grained and anodized aluminum support with an aqueous solution containing a bicarbonate as disclosed in EP-A 567178, which therefor is incorporated herein by reference.

Preferably each of the above described steps is separated by a rinsing step to avoid contamination of the liquid used in a particular step with that of the preceding step.

To promote the image sharpness and, as a consequence thereof, the sharpness of the final printed copy, the anodization layer may be coloured in the mass with an antihalation dye or pigment e.g. as described in JA-Pu-58-14,797.

Subsequent to the preparation of the hydrophilic layer of a support as described above, said hydrophilic layer may be immediately coated with a solution containing the physical development nuclei or may be coated with said solution at a later stage.

The image receiving layer preferably comprises physical development nuclei in an amount ranging from 0,1 mg to 20 mg/m². The image receiving layer containing physical development nuclei may be free of hydrophilic binder but preferably comprises small amounts upto 80% by weight of the total weight of said layer of a hydrophilic colloid e.g. polyvinyl alcohol to improve the hydrophilicity of the surface.

Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

The photosensitive layer used according to the present invention may be any layer comprising a hydrophilic colloid binder and at least one silver halide emulsion, at least one of the silver halide emulsions being photosensitive.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

For use according to the present invention the silver halide emulsion or emulsions preferably consist principally of silver chloride while a fraction of silver bromide may be present ranging from 1 mole % to 40 mole %. Most preferably a silver halide emulsion containing at least 70 mole% of silver chloride is used.

The average size of the silver halide grains may range from 0.10 to 0.70 µm , preferably from 0.25 to 0.45 µm.

Preferably during the precipitation stage iridium and/or rhodium containing compounds or a mixture of both are added. The concentration of these added compounds ranges from 10⁻⁸ to 10⁻³ mole per mole of AgNO₃, preferably between 10⁻⁷ and 10⁻⁵ mole per mole of AgNO₃.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

Apart from negative-working silver halide emulsions that are preferred for their high photosensitivity, use can be made also of direct-positive silver halide emulsions that produce a positive silver image in the emulsion layer(s) and a negative image on the image-receiving layer.

Suitable direct positive silver halide emulsions for use in accordance with the present invention are silver halide emulsions that have been previously fogged or that mainly form an internal latent image.

The silver halide emulsions of the DTR-element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. In case of exposure by an argon ion laser a blue sensizing dye is incorporated. In case of exposure by a red light emitting source, e.g. a LED or a HeNe laser a red sensitizing dye is used. In case of exposure by a semiconductor laser special spectral sensitizing dyes suited for the near infra-red are required. Suitable infra-red sensitizing dyes are disclosed in i.a. US-P 2,095,854, 2,095,856, 2,955,939, 3,482,978, 3,552,974, 3,573,921, 3,582,344, 3,623,881 and 3,695,888.

A preferred blue sensitizing dye, green sensitizing dye, red sensitizing dye and infrared sensitizing dye in connection with the present invention are described in EP-A 554,585.

To enhance the sensitivity in the red or near infra-red region use can be made of so-called supersensitizers in combination with red or infra-red sensitizing dyes. Suitable supersensitizers are described in Research Disclosure Vol 289, May 1988, item 28952. The spectral sensitizers can be added to the photographic emulsions in the form of an aqueous solution, a solution in an organic solvent or in the form of a dispersion.

The silver halide emulsions may contain the usual emulsion stabilizers. Suitable emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilizers are i.a. heterocyclic mercapto compounds.

As binder in the silver halide emulsion layer(s) in connection with the present invention a hydrophilic colloid may be used, usually a protein, preferably gelatin. Gelatin can, however, be replaced in part or integrally by synthetic, semi-synthetic, or natural polymers. Preferably the silver halide emulsion layer contains at least one gelatin species whereof a 10 % by weight aqueous solution at 36 °C and pH 6 has a viscosity lower than 20 mPa.s at a shearing rate of 1000 s⁻¹ combined with a gelatin of a higher viscosity. The weight ratio of said low viscosity gelatin versus the gelatin of a higher viscosity is preferably > 0.5.

Preferably the gelatin layer(s) is(are) substantially unhardened. Substantially unhardened means that when such gelatin layer is coated on a subbed polyethylene terephtalate film base at a dry thickness of 1.2 g/m², dried for 3 days at 57 C° and 35% R.H. and dipped in water of 30 C°, said gelatin layer is dissolved for more than 95 % by weight within 5 minutes.

The silver halide emulsions may contain pH controlling ingredients. Preferably at least one gelatin containing layer is coated at a pH value not below the iso-electric point of the gelatin to avoid interactions between said gelatin containing coated layer and the hereafter mentioned intermediate layer. More preferably the gelatin layer contiguous to said intermediate layer is coated at a pH value not below the iso-electric point of the gelatin. Most preferably all the gelatin containing layers are coated at a pH value not below the iso-electric point of their gelatin. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

More details about the composition, preparation and coating of silver halide emulsions suitable for use in accordance with the present invention can be found in e.g. Product Licensing Index, Vol. 92, December 1971, publication 9232, p. 107-109.

Preferably, the imaging element also comprises an intermediate layer between the image receiving layer on the hydrophilic surface of a support and the photosensitive layer (packet) to facilate the removal of said layer layer(packet) thereby uncovering the silver image formed in the image receiving layer by processing the imaging element.

In one embodiment, the intermediate layer is a water-swellable intermediate layer coated at a ratio of 0.01 to 2.0 g/m2 and comprising at least one non-proteinic hydrophilic film-forming polymer e.g. polyvinyl alcohol and optionally comprising an antihalation dye or pigment as disclosed in EP-A-410500.

In another embodiment, the intermediate layer is a layer comprising hydrophobic polymer beads having an average diameter not lower than 0.2 µm and having been prepared by polymerization of at least one ethylenically unsaturated monomer. Preferably, said intermediate layer in dry condition comprises said hydrophobic polymer beads in an amount of up to 80% of its total weight. Further details are disclosed in EP-A-483415.

A supplemental intermediate layer, which may be present between said silver halide emulsion containing layer and said water-swellable intermediate layer or said intermediate layer comprising hydrophobic polymer beads may incorporate one or more ingredients such as i.a. antihalation dyes or pigment, developing agents, silver halide solvents, base precursors, and anticorrosion substances.

When the imaging element is prepared by laminating a layer packet comprising a photosensitive layer onto the image receiving layer the intermediate layer(s) are provided on the photosensitive layer(s), the intermediate layer being the upper layer.

According to the present invention the imaging element can be information-wise exposed in an apparatus according to its particular application. A wide choice of cameras for exposing the photosensitive silver halide emulsion exists on the market. Horizontal, vertical and darkroom type cameras and contact-exposure apparatus are available to suit any particular class of reprographic work. The imaging element in accordance with the present invention can also be exposed with the aid of i.a. laser recorders and cathode rays tubes.

According to the present invention the development and diffusion transfer of the information-wise exposed imaging element in order to form a silver image in said photosensitive layer and to allow unreduced silver halide or complexes formed thereof to diffuse image-wise from the photosensitive layer to said image receiving layer to produce therein a silver image, are effected with the aid of an aqueous alkaline solution in the presence of (a) developing agent(s), and (a) silver halide solvent(s). The developing agent(s) and/or the silver halide solvent(s) can be incorporated in the aqueous alkaline solution and/or in the imaging element.

Preferably a silver halide solvent in the aqueous alkaline solution is used in an amount between 0.05% by weight and 5% by weight and more preferably between 0.5% by weight and 2% by weight. The silver halide solvent, which acts as a complexing agent for silver halide, preferably is a water-soluble thiosulphate or thiocyanate e.g. sodium, potassium, or ammonium thiosulphate and sodium, potassium, or ammonium thiocyanate.

Further silver halide solvents that can be used in connection with the present invention are e.g. sulphite, amines, 2-mercaptobenzoic acid, cyclic imide compounds such as e.g. uracil, 5,5-dialkylhydantoins, alkyl sulfones and oxazolidones.

Further silver halide solvents for use in connection with the present invention are alkanolamines. Examples of alkanolamines that may be used in connection with the present invention correspond to the following formula: 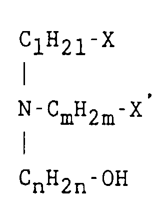 wherein X and X' independently represent hydrogen, a hydroxyl group or an amino group, 1 and m represent 0 or integers of 1 or more and n represents an integer of 1 or more. Said alkanolamines may be present in the alkaline processing liquid in a concentration preferably between 0.1% and 5% by weight. However part or all of the alkanolamine can be present in one or more layers of the imaging element.

Still other preferred further silver halide solvents for use in connection with the present invention are thioethers. Preferably used thioethers correspond to the following general formula:

Z-(R¹-S)ₜ-R²-S-R³-Y

wherein Z and Y each independently represents hydrogen, an alkyl group, an amino group, an ammonium group, a hydroxyl, a sulfo group, a carboxyl, an aminocarbonyl or an aminosulfonyl, R¹, R² and R³ each independently represents an alkylene that may be substituted and optionally contain an oxygen bridge and t represents an integer from 0 to 10. Examples of thioether compounds corresponding to the above formula are disclosed in e.g. US-P-4.960.683 and EP-A 554,585.

Still further suitable silver halide solvents are 1,2,4-triazolium-3-thiolates, triazolium-3-thiolates, preferably substituted with at least one substituent selected from the group consisting of a C₁-C₈ alkyl group that contains at least 3 fluorine atoms, a C₄-C₁₀ hydrocarbon group and a 4-amino group substituted with a C₁-C₈ alkyl group that contains at least 3 fluorine atoms and/or a C₄-C₁₀ hydrocarbon group.

Combinations of different silver halide solvents can be used and it is also possible to incorporate at least one silver halide solvent into a suitable layer of the imaging element and to add at least one other silver halide solvent to the developing solution.

The alkaline processing liquid may also contain (a) developing agent(s). In this case the alkaline processing liquid is called a developer. On the other hand some or all of the developing agent(s) may be present in one or more layers of the photographic material or imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are the 1-phenyl-3-pyrazolidinones. Even more preferred, particularly when they are incorporated into the photographic material are 1-phenyl-3-pyrazolidinones of which the aqueous solubility is increased by a hydrophilic substituent such as e.g. hydroxy, amino, carboxylic acid group, sulphonic acid group etc.. Examples of 1-phenyl-3-pyrazolidinones subsituted with one or more hydrophilic groups are e.g. 1-phenyl-4,4-dimethyl-2-hydroxy-3-pyrazolidone, 1-(4-carboxyphenyl)-4,4-dimethyl-3-pyrazolidone etc.. However other developing agents can be used.

Preferred amounts of the hydroquinone-type developing agents are in the range of 0.05 mole to 0.40 mole per litre and preferred amounts of secondary developing agent(s) in the range of 1.8 x 10⁻³ to 2.0 x 10⁻¹ mole per litre.

The aqueous alkaline solution in accordance with the present invention may further comprise sulphite e.g. sodium sulphite in an amount ranging from 40 g to 180 g per liter, preferably from 60 to 160 g per liter in combination with another silver halide solvent.

The quantitative ranges given for the developing agents, silver halide solvents, and sulphite apply to the amount of these compounds present as solutes in the aqueous alkaline solution during the DTR-processing, whether these compounds make part of the aqueous alkaline solution or were dissolved from the layers containing them upon application thereto of the aqueous alkaline solution.

The aqueous alkaline solution suitable for use according to the present invention preferably comprises aluminum ions in an amount of at least 0.3 g/l, more preferably in an amount of at least 0.6 g/l in order to prevent sticking of the emulsion layer to the transporting rollers when the emulsion is swollen with the aqueous alkaline solution.

The alkaline processing liquid preferably has a pH between 9 and 14 and more preferably between 10 and 13, but depends on the type of silver halide emulsion material to be developed, intended development time, and processing temperature.

The processing conditions such as temperature and time may vary within broad ranges provided the mechanical strength of the materials to be processed is not adversely influenced and no decomposition takes place.

The pH of the alkaline processing liquid may be established by an organic or inorganic alkaline substance or a combination thereof. Suitable inorganic alkaline substances are e.g. hydroxides of sodium and potassium, alkali metal salts of phosphoric acid and/or silicic acid e.g. trisodium phosphate, orthosilicates, metasilicates, hydrodisilicates of sodium or potassium, and sodium carbonate etc.. Suitable organic alkaline substances are e.g. alkanolamines. In the latter case the alkanolamines will provide or help providing the pH and serve as a silver halide complexing agent.

The aqueous alkaline solution may further comprise hydrophobizing agents for improving the hydrophobicity of the silver image obtained in the image receiving layer. Generally these compounds contain a mercapto group or thiolate group and one or more hydrophobic substituents. Particularly preferred hydrophobizing agents are mercapto-1,3,4-thiadiazoles as described in DE-A 1,228,927 and in US-P 4,563,410, 2-mercapto-5-heptyl-oxa-3,4-diazole and long chain (at least 5 carbon atoms) alkyl substituted mercaptotetrazoles. The hydrophobizing agents can be used alone or in combination with each other.

These hydrophobizing compounds can be added to the aqueous alkaline solution in an amount of preferably 0.1 to 3 g per litre and preferably in admixture with 1-phenyl-5-mercaptotetrazole, the latter compound may be used in amounts of e.g. 50 mg to 1.2 g per litre of solution, which may contain a minor amount of ethanol to improve the dissolution of said compounds.

The aqueous alkaline solution may comprise other ingredients such as e.g. oxidation preservatives, calcium-sequestering compounds, anti-sludge agents, and hardeners including latent hardeners.

Regeneration of the aqueous alkaline solution according to known methods is, of course, possible, whether the solution incorporates developing agent(s) and/or silver halide solvent(s) or not.

The development may be stopped - though this is often not necessary - with a so-called stabilization liquid, which actually is an acidic stop-bath having a pH preferably in the range from 5 to 7.

Bufferred stop bath compositions comprising a mixture of sodium dihydrogen orthophosphate and disodium hydrogen orthophosphate and having a pH in said range are preferred.

The development and diffusion transfer can be initiated in different ways e.g. by rubbing with a roller, by wiping with an absorbent means e.g. with a plug of cotton or sponge, or by dipping the material to be treated in the liquid composition. Preferably, they proceed in an automatically operated apparatus. They are normally carried out at a temperature in the range of 18°C to 30°C and in a time from 5 s to 5 min.

After formation of the silver image on the hydrophilic surface of a support an excess of aqueous alkaline solution still present on the base may be eliminated, preferably by guiding the foil through a pair of squeezing rollers.

The silver image thus obtained in the layer of physical development nuclei is subsequently uncovered by treating the imaging element to remove all the layers above the layer containing physical development nuclei, thereby exposing the imaged surface of the hydrophilic support.

According to a particularly preferred embodiment of the present invention the silver image in the layer of physical development nuclei is uncovered by washing off all the layers above the layer containing physical development nuclei with rinsing water.

The temperature of the rinsing water may be varied widely but is preferably between 30 °C and 50 °C, more preferably between 35°C and 45°C.

The imaged surface of the hydrophilic surface of a support can be subjected to a chemical treatment that increases the hydrophilicity of the non-silver image parts and the oleophilicity of the silver image

This chemical after-treatment is preferably carried out with a lithographic composition often called finisher comprising at least one compound enhancing the ink-receptivity and/or lacquer-receptivity of the silver image and at least one compound that improves the ink-repelling characteristics of the hydrophilic surface.

Suitable ingredients for the finisher are e.g. organic compounds containing a mercapto group such as the hydrophobizing compounds referred to hereinbefore for the alkaline solution. Preferred compounds correspond to one of the following formulas: 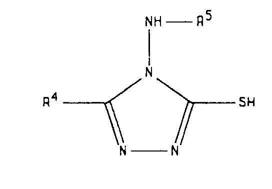 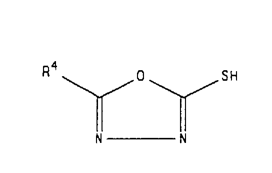 wherein R⁵ represents hydrogen or an acyl group, R⁴ represents alkyl, aryl or aralkyl. Most preferably used compounds are compounds according to one of the above formulas wherein R⁴ represents an alkyl containing 3 to 16 C-atoms. Said (a) hydrophobizing agent(s) is(are) comprised in the finisher preferably in a total concentration between 0.1 g/l and 10 g/l, more preferably in a total concentration between 0.3 g/l and 3 g/l.

Additives improving the oleophilic ink-repellency of the hydrophilic surface areas are e.g. carbohydrates such as acidic polysaccharides like gum arabic, carboxymethylcellulose, sodium alginate, propylene glycol ester of alginic acid, hydroxyethyl starch, dextrin, hydroxyethylcellulose, polyvinyl pyrrolidone, polystyrene sulphonic acid, polyglycols being the reaction products of ethyleneoxide and/or propyleneoxide with water or an alcohol and polyvinyl alcohol. Optionally, hygroscopic substances e.g. sorbitol, glycerol, tri(hydroxyethyl)ester of glycerol, and turkish red oil may be added.

Furthermore (a) surface-active compound(s) is preferably also added to the finisher. The concentration thereof may vary within broad ranges provided the finisher shows no excessive degree of foaming when plates are finished. Preferred surface-active compound are anionic or non-ionic surface-active compound.

A suitable finisher as disclosed in US-A-4.563.410 is a composition comprising a solution of a mercaptotriazole in a solution of polyethylene oxide with a molecular weight of 4,000. Further suitable finishers have been described in i.a. US-A 4.062.682.

At the moment the treatment with the finisher is started the surface carrying the silver pattern may be in dry or wet state. In general, the treatment with the finisher does not take long, usually not longer than about 30 seconds and it may be carried out immediately after the processing and uncovering steps, preferably at a temperature of the finisher in the range from 30°C to 60°C.

The finisher can be applied in different ways such as by rubbing with a roller, by wiping with an absorbent means e.g. with a plug of cotton or sponge, or by dipping the material to be treated in the finisher. The image-hydrophobizing step of the printing plate may also proceed automatically by conducting the printing plate through a device having a narrow channel filled with the finisher and conveying the printing plate at the end of the channel between two squeezing rollers removing the excess of liquid.

As soon as the hydrophilic surface of a support carrying the silver image has been treated with the finisher, it is ready to be used as a printing plate.

The following example illustrates the present invention without however, limiting it thereto. All parts, percentages and ratios are by weight unless otherwise indicated.

### EXAMPLE 1 ( Comparative example)

A 0,30 mm thick aluminium foil (AA 1050) was degreased by immersing the foil in an aqueous solution containing 10 % phosphoric acid and subsequently etched in an aqueous solution containing 2 g/l of sodium hydroxide. The foil was then electrochemically grained using an alternating current in an aqueous solution containing 4 g/l of hydrochloric acid and 4 g/l of hydroboric acid at a temperature of 35°C to form a surface topography with an average center-line roughness Ra of 0,6 µm. The aluminium plate was then desmutted with an aqueous solution containing 30 % of sulfuric acid at 60°C for 120 seconds. The foil was subsequently subjected to anodic oxidation in a 20 % sulfuric acid aqueous solution to form an anodic oxidation film of 3.0 g/m² of Al₂O₃.H₂O, treated with an aqueous solution containing 20 g/l of NaHCO₃ at 45°C for 30 sec and then rinsed with demineralised water and dried.

The imaging element I was obtained by coating the grained, anodized and posttreated aluminum support with a silver-receptive stratum containing 1.1 mg/m² PdS as physical development nuclei.

An intermediate layer was then provided on the dry silver-receptive stratum from an aqueous composition in such a way that the resulting dried layer had a weight of 0.5 g of polymethyl methacrylate beads per m², said composition comprising:

| | |
|---|---|
| a 20 % dispersion of polymethyl methacrylate beads in a mixture of equal volumes of water and ethanol having an average diameter of 1.0 µm | 50 ml |
| Helioechtpapierrot BL (trade mark for a dye sold by BAYER AG, D-5090 Leverkusen, West-Germany) | 2.5 g |
| saponine | 2.5 g |
| sodium oleylmethyltauride | 1.25 g |
| demineralized water | 300 ml |
| (pH-value : 5.6) | |

Finally a substantially unhardened photosensitive negative-working cadmium-free gelatin silver chlorobromoiodide emulsion layer (97.98 / 2 / 0.02 mol%) containing 1 mmole/mole AgX of 4-hydroxy-6-methyl-1,3,3a,7-tetraazaindene was coated on the intermediate layer, the silver halide being provided in an amount corresponding to 2.40 g of silver nitrate per m² and the gelatin content of the emulsion layer being 1.58 g/m², consisting of 0.7 g/m² of a gelatin with a viscosity of 21 mPa.s and the remainder of a gelatin with a viscosity of 14 mPa.s

Imaging elements II and III were obtained in an identical way as imaging element I with the exception that the photosensitive emulsion layer was overcoated with an antistress layer containing no hardeners comprising 0.5 and 1 g/m² gelatin with a viscosity of 38-42 mPa.s ( gelatin K 16353 of Koepff).

Imaging elements IV and V were obtained in an identical way as imaging element I with the exception that the photosensitive emulsion layer was overcoated with an antistress layer containing no hardeners comprising 0.5 and 1 g/m² gelatin with a viscosity of 27-29 mPa.s ( gelatin K 10239 of Koepff.)

The imaging elements were placed in contact with a test target having lines of dots having the same size in one line and having dots of different sizes in different lines and exposed therethrough in a process-camera. In the next step each imaging element was immersed for 10 s at 24°C in a freshly made developing solution having the following composition:

| | |
|---|---|
| carboxymethylcellulose | 4 g |
| sodium hydroxide | 22.5 g |
| anhydrous sodium sulphite | 120 g |
| hydroquinone | 20 g |
| 1-phenyl-4-methyl-3-pyrazolidinone | 6 g |
| potassium bromide | 0.75 g |
| anhydrous sodium thiosulphate | 8 g |
| ethylene diamine tetraacetic acid tetrasodium salt | 2 g |
| demineralized water to make | 1000 ml |
| pH (24°C) = 13 | |

The initiated diffusion transfer was allowed to continue for 20 s to form a silver image in the image receiving layers.

To remove the developed silver halide emulsion layer and the intermediate layer from the aluminium foil the developed monosheet DTR materials were rinsed for 5 s with a water jet at 40°C in a LP 82 (tradename of a processor marketed by Agfa-Gevaert, Belgium).

Next, the imaged surfaces of the aluminium foils were guided for 15 s through a finisher at 20 °C to enhance the water-receptivity of the non-image areas and to make the image areas oleophilic ink-receptive. The finisher had the following composition :

| | |
|---|---|
| 10% aqueous n-hexadecyl trimethyl ammonium chloride | 25 ml |
| 20% aqueous solution of polystyrene sulphonic acid | 100 ml |
| potassium nitrate | 12.5 g |
| citric acid | 20.0 g |
| 1-phenyl-5-mercaptotetrazole | 2.0 g |
| sodium hydroxide | 5.5 g |
| water to make | 1000 ml |
| pH (20°C) = 4 | |

The size of the dots of the line with the smallest dots whereof all the dots were represented on the printing plate was measured and is called the smallest represented dot on the printing plate.

The printing plates thus prepared were mounted on the same offset printing machine (ROTOMATIC R-35) and were used for printing under identical conditions. Commercial AQUA TAME 7035E, marketed by Anchor/Lithemko Inc., Florida, was used at a 5 % concentration in an aqueous solution containing 10 % isopropanol as dampening solution and K+E 123 W, marketed by Kast+Ehinger, A.G., Germany, was used as ink. A compressible rubber blanket was used.

The size of the dots of the line with the smallest dots whereof all the dots were represented on the print was measured and is called the smallest represented dot on the print. In the following step the difference between the smallest represented dot on the printing plate and the smallest represented dot on the print were calculated.

This whole operation was repeated six times and the average of said six calculated differences between the smallest represented dot on the printing plate and the smallest represented dot on the print is called the match between a printing plate and the print.

The resulting values for the match relating to the printing plates obtained from the imaging elements I to V is given in table 1.

**Table 1**

| No. | Imaging element | Match (in µm) |
|---|---|---|
| 1 | I | 2.75 |
| 2 | II | 2.25 |
| 3 | III | 1 |
| 4 | IV | 2.25 |
| 5 | V | 0.5 |

It is clear from these results that a printing plate obtained from an imaging element having an antistress layer of 1g/m² of a gelatin with a viscosity of 38-42 mPa.s (imaging element III) has a much improved match compared with a printing plate obtained from an imaging element having no antistress layer (imaging element I) or an antistress layer of 0.5 g/m² of a gelatin with a viscosity of 38-42 mPa.s (imaging element II). However, the improvement is clearly better with a a printing plate obtained from an imaging element having an antistress layer of also 1g/m² but of a gelatin with a viscosity of 27-29 mPa.s (imaging element according to the invention V).

### EXAMPLE 2 ( Comparative example)

Imaging elements VI, VII and VIII were obtained in an identical way as imaging element I with the exception that the photosensitive emulsion layer was overcoated with an antistress layer comprising 1, 1.5 and 2 g/m² gelatin with a viscosity of 38-42 mPa.s (gelatin K 16353 of Koepff).

Imaging elements IX, X and XI were obtained in an identical way as imaging element I with the exception that the photosensitive emulsion layer was overcoated with an antistress layer comprising 1, 1.5 and 2 g/m² gelatin with a viscosity of 10-12 mPa.s (gelatin K 7598 of Koepff.)
The imaging elements I and VI to XI were exposed, processed, used to print and evaluated as described in example 1. The results regarding match are given in table 2.

**Table 2**

| No. | Imaging element | Match (in µm) |
|---|---|---|
| 1 | I | 4.5 |
| 2 | VI | 3.25 |
| 3 | VII | 3.25 |
| 4 | VII | 3.25 |
| 5 | IX | 2 |
| 6 | X | 2.75 |
| 7 | XI | 3.25 |

It is clear from these results that imaging elements having no antistress (imaging element I) or an antistress layer consisting of gelatin with a viscosity of 38-42 mPa.s (imaging elements VI to VII) or an antistress layer of 2 g/m² gelatin (imaging element XI) gave a (much) worse match than imaging elements having an antistress layer comprising 1 or 1.5 g/m² gelatin with a viscosity of 10-12 mPa.s (imaging elements IX and X according to the invention).

## Claims

1. An imaging element comprising in the order given on a hydrophilic surface of a support (i) an image receiving layer containing physical development nuclei, (ii) a photosensitive layer containing a silver halide emulsion being in water permeable relationship with said image receiving layer and (iii) an antistress composition in water permeable relationship with said image receiving layer, said antistress composition comprising unhardened gelatin in an amount ranging from 0.60 to 1.75 g/m² , characterized in that at least 50% by weight of said unhardened gelatin belongs to one or more gelatin species whereof a 10% by weight aqueous solution at 36°C and pH 6 has a viscosity lower than 35 mPa.s at a shearing rate of 1000 s⁻¹.

2. An imaging element according to claim 1 wherein said antistress composition comprises unhardened gelatin in an amount ranging from 0.80 to 1.25 g/m².

3. An imaging element according to claim 1 or 2 wherein at least 75% by weight of said unhardened gelatin belongs to one or more gelatin species whereof a 10% by weight aqueous solution at 36°C and pH 6 has a viscosity lower than 35 mPa.s

4. An imaging element according to any of claims 1 to 3 wherein at least 50% of said unhardened gelatin belongs to one or more gelatin species whereof a 10% by weight aqueous solution at 36°C and pH 6 has a viscosity lower than 30 mPa.s at a shearing rate of 1000 s⁻¹.

5. An imaging element according to any of claims 1 to 4 wherein said antistress composition comprises only one species of unhardened gelatin whereof a 10% by weight aqueous solution at 36°C and pH 6 has a viscosity lower than 35 mPa.s at a shearing rate of 1000 s⁻¹.

6. An imaging element according to any of claims 1 to 5 wherein said antistress composition comprises small particles with a mean diameter between 0.2 and 10 µm.

7. An imaging element according to any of claims 1 to 6 wherein said antistress composition consist of only one layer.

8. An imaging element according to any of claims 1 to 7 wherein said hydrophilic surface of a support is a grained and anodized aluminum foil.

9. A method for making an offset printing plate according to the silver salt diffusion transfer process comprising the steps of:
(a) image-wise exposing an imaging element according to any of claims 1 to 8,
(b) applying an aqueous alkaline solution to the imaging element in the presence of (a) developing agent(s) and (a) silver halide solvent(s) ,
(c) treating the imaging element to remove the layer(s) on top of said image receiving layer, thereby uncovering said silver image formed in said image receiving layer.

## Patentansprüche

1. Ein bilderzeugendes Element, das der angegebenen Reihe nach auf einer hydrophilen Oberfläche eines Trägers (i) eine physikalische Entwicklungskeime enthaltende Bildempfangsschicht, (ii) eine lichtempfindliche Silberhalogenid-Emulsionsschicht in wasserdurchlässiger Beziehung zur Bildempfangsschicht und (iii) eine Schutzschichtzusammensetzung in wasserdurchlässiger Beziehung zur Bildempfangsschicht enthält, wobei die Schutzschichtzusammensetzung nicht-gehärtete Gelatine in einer Menge zwischen 0,60 und 1,75 g/m² enthält, dadurch gekennzeichnet, daß wenigstens 50 Gew.-% der Gelatine zu einer oder mehreren Gelatinearten gehört, von der (denen) eine wäßrige 10 gew.-%ige Lösung bei 36°C und einem pH von 6 eine Viskosität von weniger als 35 mPa.s bei einer Schergeschwindigkeit von 1.000 s⁻¹ aufweist.

2. Bilderzeugendes Element nach Anspruch 1, dadurch gekennzeichnet, daß die Schutzschichtzusammensetzung nicht-gehärtete Gelatine in einer Menge zwischen 0,80 und 1,25 g/m² enthält.

3. Bilderzeugendes Element nach Anspruch 1 oder 2, dadurch gekennzeichnet, daß wenigstens 75 Gew.-% der nicht-gehärteten Gelatine zu einer oder mehreren Gelatinearten gehört, von der (denen) eine wäßrige 10 gew.-%ige Lösung bei 36°C und einem pH von 6 eine Viskosität von weniger als 35 mPa.s aufweist.

4. Bilderzeugendes Element nach irgendeinem der Ansprüche 1 bis 3, dadurch gekennzeichnet, daß wenigstens 50 Gew.-% der nicht-gehärteten Gelatine zu einer oder mehreren Gelatinearten gehört, von der (denen) eine wäßrige 10 gew.-%ige Lösung bei 36°C und einem pH von 6 eine Viskosität von weniger als 30 mPa.s bei einer Schergeschwindigkeit von 1.000 s⁻¹ aufweist.

5. Bilderzeugendes Element nach irgendeinem der Ansprüche 1 bis 4, dadurch gekennzeichnet, daß die Schutzschichtzusammensetzung nur eine Art von nicht-gehärteter Gelatine enthält, von der eine wäßrige 10 gew.-%ige Lösung bei 36°C und einem pH von 6 eine Viskosität von weniger als 35 mPa.s bei einer Schergeschwindigkeit von 1.000 s⁻¹ aufweist.

6. Bilderzeugendes Element nach irgendeinem der Ansprüche 1 bis 5, dadurch gekennzeichnet, daß die Schutzschichtzusammensetzung kleine Teilchen mit einem mittleren Durchmesser zwischen 0,2 und 10 µm enthält.

7. Bilderzeugendes Element nach irgendeinem der Ansprüche 1 bis 6, dadurch gekennzeichnet, daß die Schutzschichtzusammensetzung aus einer einzelnen Schicht besteht.

8. Bilderzeugendes Element nach irgendeinem der Ansprüche 1 bis 7, dadurch gekennzeichnet, daß die hydrophile Oberfläche eines Trägers eine gekörnte und eloxierte Aluminiumfolie ist.

9. Ein Verfahren zur Herstellung einer Offsetdruckplatte nach dem Silbersalz-Diffusionsübertragungsverfahren, das folgende Stufen umfaßt :
(a) die bildmäßige Belichtung eines bilderzeugenden Elements nach irgendeinem der Ansprüche 1 bis 8,
(b) den Auftrag einer wäßrigen alkalischen Lösung auf das bilderzeugende Element in Gegenwart einer oder mehrerer Entwicklersubstanzen und eines oder mehrerer Silberhalogenid-Lösungsmittel,
(c) die Verarbeitung des bilderzeugenden Elements zur Entfernung der auf der Bildempfangsschicht befindlichen Schicht(en), wodurch das in der Bildempfangsschicht erzeugte Silberbild aufgedeckt wird.

## Revendications

1. Elément de formation d'image comprenant, dans l'ordre donné, sur une surface hydrophile d'un support, (i) une couche de réception d'image contenant des germes de développement physique, (ii) une couche photosensible contenant une émulsion à l'halogénure d'argent en relation de perméabilité à l'eau avec ladite couche de réception d'image, et (iii) une composition de projection en relation de perméabilité à l'eau avec ladite couche de réception d'image, ladite composition de protection comprenant de la gélatine non durcie en une quantité dans le domaine de 0,60 à 1,75 g/m², caractérisé en ce qu'au moins 50% en poids de ladite gélatine non durcie appartiennent à une ou plusieurs espèces de gélatines dont une solution aqueuse, à concurrence de 10% en poids à 36°C et à un pH de 6, possède une viscosité inférieure à 35 mPa.s, à une vitesse de cisaillement de 1000 s⁻¹.

2. Elément de formation d'image selon la revendication 1, dans lequel ladite composition de protection comprend de la gélatine non durcie en une quantité dans le domaine de 0,80 à 1,25 g/m,².

3. Elément de formation d'image selon la revendication 1 ou 2, dans lequel au moins 75% en poids de ladite gélatine non durcie appartiennent à une ou plusieurs espèces de gélatines dont une solution aqueuse, à concurrence de 10% en poids à 36°C et à un pH de 6, possède une viscosité inférieure à 35 mPa.s.

4. Elément de formation d'image selon les revendications 1 à 3, dans lequel au moins 50% de ladite gélatine non durcie appartiennent à une ou plusieurs espèces de gélatines dont une solution aqueuse, à concurrence de 10% en poids à 36°C et à un pH de 6, possède une viscosité inférieure à 30 mPa.s, à une vitesse de cisaillement de 1000 s⁻¹.

5. Elément de formation d'image selon l'une quelconque des revendications 1 à 4, dans lequel ladite composition de protection comprend une seule espèce de gélatine non durcie dont une solution aqueuse, à concurrence de 10% en poids à 36°C et à un pH de 6, possède une viscosité inférieure à 35 m.Pa.s, à une vitesse de cisaillement de 1000 s⁻¹.

6. Elément de formation d'image selon l'une quelconque des revendications 1 à 5, dans lequel ladite composition de protection comprend de petites particules possédant un diamètre moyen entre 0,2 et 10 µm.

7. Elément de formation d'image selon l'une quelconque des revendications 1 à 6, dans lequel ladite composition de protection est constituée d'une seule couche.

8. Elément de formation d'image selon l'une quelconque des revendications 1 à 7, dans lequel ladite surface hydrophile d'un support est une feuille d'aluminium grainée et anodisée.

9. Procédé pour fabriquer un cliché d'impression offset conformément au procédé de transfert de sels d'argent par diffusion, comprenant les étapes consistant à:
(a) exposer en forme d'images un élément de formation d'image selon l'une quelconque des revendications 1 à 8;
(b) appliquer une solution alcaline aqueuse sur l'élément de formation d'image en présence d'un ou de plusieurs agents développateurs et d'un ou de plusieurs solvants pour l'halogénure d'argent;
(c) traiter l'élément de formation d'image pour éliminer la ou les couches par-dessus ladite couche de réception d'image pour ainsi mettre à nu ladite image argentique formée dans ladite couche de réception d'image.
